Europäisches Patentamt

European Patent Office

Office européen des brevets

(19)

(11) Publication number: **0 168 246 B1**

## (12) EUROPEAN PATENT SPECIFICATION

(45) Date of publication of patent specification: **18.12.91**

(51) Int. Cl.⁵: **G11C 11/409**, H03K 19/017, H03K 3/356

(21) Application number: **85304920.3**

(22) Date of filing: **10.07.85**

(54) **Improved active pull-up circuit.**

(30) Priority: **10.07.84 JP 143004/84**

(43) Date of publication of application:
**15.01.86 Bulletin 86/03**

(45) Publication of the grant of the patent:
**18.12.91 Bulletin 91/51**

(84) Designated Contracting States:
**DE GB IT**

(56) References cited:
**EP-A- 0 040 001**
**EP-A- 0 080 936**
**US-A- 4 144 590**

**PATENT ABSTRACTS OF JAPAN, vol. 2, no. 90, 22nd July 1978, page 4126 E 78; & JP-A-53 54 428 (NIPPON DENKI K.K.) 17-05-1978**

**ELECTRONICS & COMMUNICATIONS IN JAPAN, vol. 65, no. 3, March 1982, pages 85-92, Silver Spring, Maryland, US; K. FUJISHIMA et al.: "Dynamic MOS RAM by midpoint precharge"**

(73) Proprietor: **NEC CORPORATION**
**7-1, Shiba 5-chome Minato-ku**
**Tokyo 108-01(JP)**

(72) Inventor: **Fukuzo, Yukio c/o NEC Corporation**
**33-1, Shiba 5-chome Minato-ku**
**Tokyo(JP)**
Inventor: **Inoue, Yasukazu c/o NEC Corporation**
**33-1, Shiba 5-chome Minato-ku**
**Tokyo(JP)**

(74) Representative: **Pritchard, Colin Hubert et al**
**Mathys & Squire 10 Fleet Street**
**London EC4Y 1AY(GB)**

## Description

The present invention relates to an active pull-up circuit and more particularly to an active pull-up circuit suitable for a dynamic memory circuit composed of field effect transistors.

Active pull-up circuits have been advantageously utilized in dynamic circuits, especially in dynamic memories in order to establish potentials equal to or above power supply voltages at predetermined circuit nodes. For example, in a dynamic memory, an active pull-up circuit is provided for each bit line. In this memory, a read-out signal produced on a bit line is once distinguished as one of the binary logic levels by a sense amplifier and thereafter in the case where the read-out signal is high, the potential of that bit line is pulled-up to above a power supply voltage (Vcc) by the active pull-up circuit so that the pulled-up potential on that bit line is re-written into the addressed memory cell, as well as being taken out to an output circuit. In dynamic memories, active pull-up circuits must be provided for the respective bit lines and hence the number of the active pull-up circuits has become very large because of the recent increase in memory capacity of dynamic memories. Therefore the whole area occupied by the active pull-up circuits and the whole power consumption caused by the active pull-up circuits in a dynamic memory have become important in evaluating a memory. For example, the typical prior art active pull-up circuit is composed of four field effect transistors and a capacitor and is adapted to operate by two or more control signals. Therefore, it has been difficult to fabricate such prior art active pull-up circuits in the memory chip with ease.

EP-A-0.080.936 discloses a dynamic semiconductor memory device including two bit lines connected to a sense amplifier and an active pull-up circuit for each bit line. Each active pull-up circuit contains three transistors and a capacitor ie. a first field effect transistor connected between a bit line and a power voltage terminal and second and third field effect transistors connected in series between the bit line and the voltage terminal. The junction between the second and third transistors is connected to the gate of the first transistor. The capacitor has one end connected to the gate of the first transistor. A clock signal is applied to the other end of the capacitor.

It is one object of the present invention to provide an active pull-up circuit which can be fabricated with reduced number of elements.

It is another object of the present invention to provide an active pull-up circuit operable by a small power consumption and suitable for dynamic memories.

According to the present invention there is provided an active pull-up circuit comprising a voltage terminal, a first circuit node, a first field effect transistor of an enhancement type having a drain-source path coupled between said first circuit node and said voltage terminal, a second field effect transistor of a depletion type having a drain-source path coupled between said first circuit node and a gate of said first transistor, a capacitor having a first terminal coupled to the gate of said first transistor, a first means for applying a control signal to a second terminal of said capacitor, a second means for operatively applying a first signal to said first circuit node, a third means for operatively applying a second signal to a second circuit node connected to a gate of said second transistor, each of said first and second signals having a first level which makes said second transistor conductive prior to a first time point, said first signal taking one of a second level, which is substantially the same as said first level and does not change the conductive state of said second transistor, and a third level, after said first time point, said second signal taking the other of said second level and said third level, which makes said second transistor non-conductive, after said first time point, whereby when said first signal is at the second level and said second signal is at said third level the second field effect transistor is non-conductive, the application of said control signal to the second terminal of said capacitor then causing the first transistor to conduct and causing the voltage at said voltage terminal to be applied to said first circuit node.

When the first circuit node is at a high potential while the second circuit node is at a low potential, the second transistor assumes a nonconducting state and the clock signal is directly applied to the first transistor. Thus, the power voltage is effectively supplied to the fast circuit node. On the contrary, when the first and second circuit nodes are at low and high potentials, respectively, the second transistor is rendered conducting to charge the gate of the first circuit node at low level. Accordingly, the first transistor is kept non-conducting irrespective of the clock signal.

The active pull-up circuit thus constructed is composed of two transistors and a capacitor and requires no special clock signal which is raised above the power voltage, the integrated circuit having the large integration structure and operable with a small power consumption can be obtained.

The invention will now be described, by way of example, with reference to the accompanying drawings, in which:-

Fig. 1 is a schematic circuit diagram showing the major part of a memory employing the prior art active pull-up circuit;

Fig. 2 is a timing chart showing an operation of the circuit of Fig. 1;

Fig. 3 is a schematic circuit diagram showing the major part of a memory employing the active pull-up circuit according to the invention; and

Fig. 4 is a timing chart showing an operation of the circuit of Fig. 3.

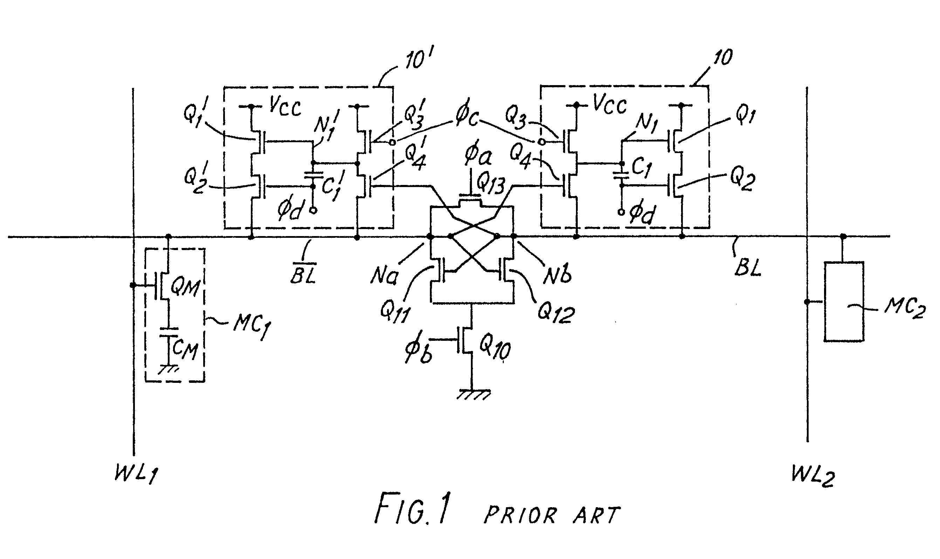

Fig. 1 shows a part of a memory circuit arrangement with the conventional active pull-up circuits.

A pair of bit lines BL and $\overline{BL}$ are connected to a pair of input/output nodes Nb and Na of a sense amplifier composed of field effect transistors $Q_{10}$ to $Q_{13}$, respectively. Memory cells $MC_1$, $MC_2$——— each composed of a cell transistor QM and a capacitor CM are arranged in a known manner with respect to word lines $WL_1$, $WL_2$ and the bit lines. Active pull-up circuits 10 and $10^1$ are provided for the bit lines BL and $\overline{BL}$, respectively. The pull-up circuit 10 operatively raises the potential of the bit line BL up to a power voltage Vcc when the potential of the bit line BL is higher than that of the bit line $\overline{BL}$. Similarly, the pull-up circuit $10^1$ operatively raises the potential of the bit line $\overline{BL}$ to the power voltage Vcc when the potential of the bit line $\overline{BL}$ is higher than that of the bit line BL. The pull-up circuit 10 is composed of transistors $Q_1$ to $Q_4$ and a capacitor $C_1$. Control clocks ${}^\emptyset c$ and ${}^\emptyset d$ are employed to operate the pull-up circuit 10. The pull-up circuit $10^1$ connected to the bit line $\overline{BL}$ has the similar structure.

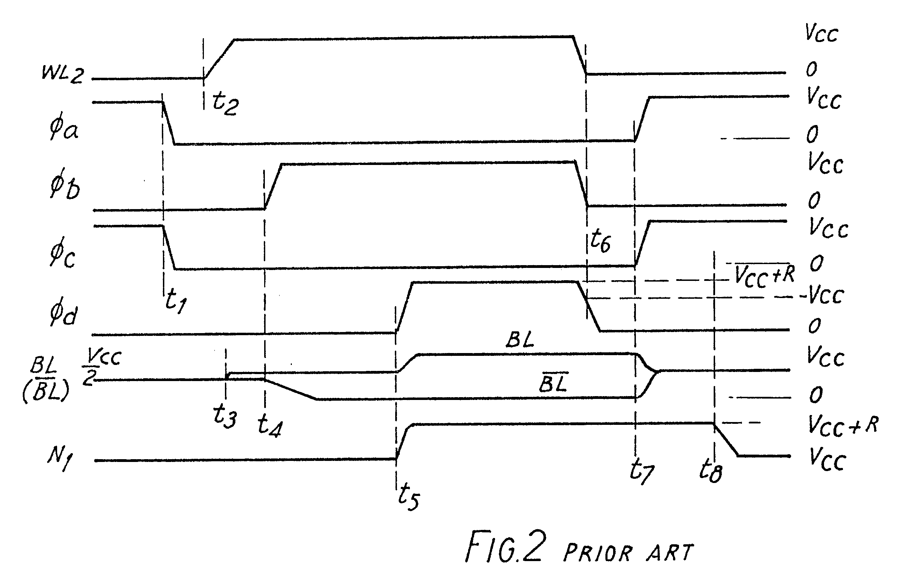

The operation of the circuit shown in Fig. 1 is described with reference to Fig. 2.

First, the signal ${}^\emptyset c$ is kept above the potential Vcc to render the transistors $Q_3$ and $Q_31$ so that the nodes $N_1$ and $N_11$ are charged to Vcc. Namely, the capacitors $C_1$ and $C_11$ are charged to Vcc. Also, the transistor $Q_{13}$ is rendered conductive to set the bit lines BL and $\overline{BL}$ at a potential of Vcc/2 in response to a high level of the signal ${}^\emptyset a$. Then, the signals ${}^\emptyset a$ and ${}^\emptyset c$ are changed to low level at a time point $t_1$ that is the end of reset period. Subsequently, the word line eg. $WL_2$ is driven towards a selection level from a time point $t_2$. In response thereto, a stored signal of the cell $MC_2$ storing "1" is read-out on the bit line BL to slightly raise the potential of the bit line BL from Vcc/2 at a time point $t_3$ while the potential of the bit line $\overline{BL}$ remains unchanged. Then, the signal ${}^\emptyset b$ changes from low level to high level thereby to enable the sense amplifier at a time point $t_4$ so that the charge at the bit line $\overline{BL}$ is discharged to the ground potential by the sense amplifier. Then, at a time point $t_5$, the signal ${}^\emptyset d$ is raised above the Vcc level so that the gate potential of the node $N_1$ is raised far above the Vcc level. Thus, the transistors $Q_1$ and $Q_2$ are conducting in non-saturated region, i.e. triode region to supply the bit line BL with the Vcc level. While, in this instance, the transistor $Q_41$ in the

pull-up circuit $10^1$ assumes conducting state because the potential of the gate of the transistor $Q_41$ is high so that the charge at the node $N_11$ is discharged towards the ground potential through the transistors $Q_41$ and $Q_{11}$. Thus, the potential the bit line $\overline{BL}$ remains low. Then, at a time point $t_6$, the word line $WL_2$ and the signals ${}^\emptyset b$ and ${}^\emptyset d$ return to low level to finish access operation. Then, at a time point $t_7$, the signal ${}^\emptyset a$ changes low level to high level thereby to set the bit lines BL and $\overline{BL}$ the same level of Vcc/2 and the signals return to high level above the Vcc level. Thus, the reset period is introduced.

As has been described, four transistors $Q_1$ to $Q_4$ are required to form the pull-up circuit 10 and hence it has been difficult to fabricate the pull-up circuit in a small area. Moreover, in order to operate the circuit 10, two clock signals ${}^\emptyset c$ and ${}^\emptyset d$ are necessary, and the circuit structure for generating such signals has been complicated and consuming a relatively large power.

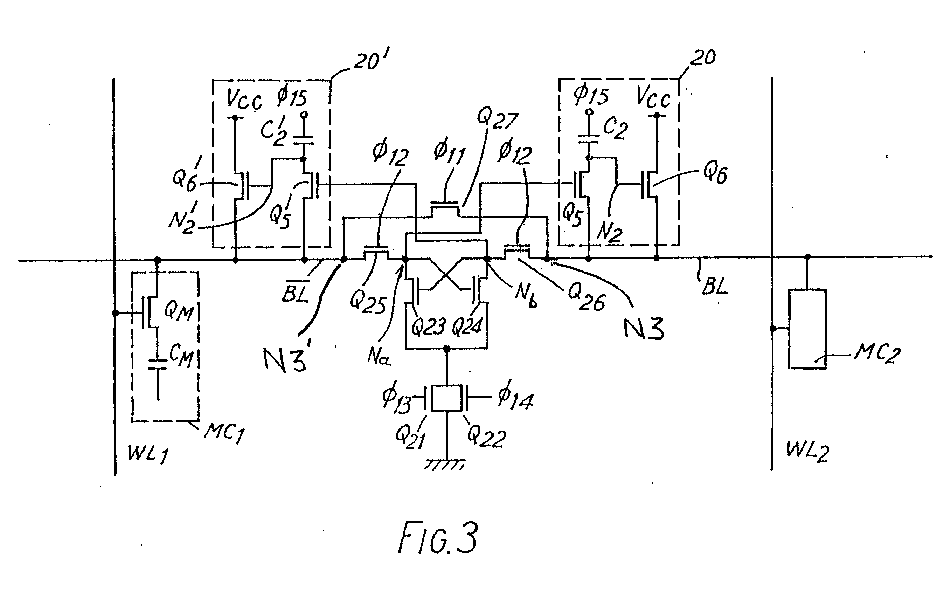

Referring to Fig. 3, a preferred embodiment of the present invention is described for the case where the active pull-up circuit of the invention is applied to a dynamic memory.

A pair of bit lines BL and $\overline{BL}$ are connected to respective first circuit nodes (N3, N3') which are in turn connected to respective input/output nodes Nb and Na of a sense amplifier. The amplifier is composed of enhancement type FETs $Q_{21}$ to $Q_{27}$. The nodes Nb and Na are connected to the amplifier via transfer gate transistors $Q_{26}$ and $Q_{25}$ of enhancement type FETs, respectively. An active pull-up circuit 20 for the bit line BL is composed of an enhancement type FET $Q_6$ having a drain-source connected between the bit line BL and the power voltage Vcc, a depletion type FET $Q_5$ having a source connected to the bit line BL and a gate connected to the input/output node Na, and a capacitor $C_2$ coupled between the drain of the transistor $Q_5$ and a clock terminal ${}^\emptyset 15$. An active pull-up circuit $20^1$ for the bit line $\overline{BL}$ has a similar structure. A threshold voltage VTD of the depletion transistors $Q_5$ and $Q_51$ is defined by "0 > VTD > -1/2 Vcc".

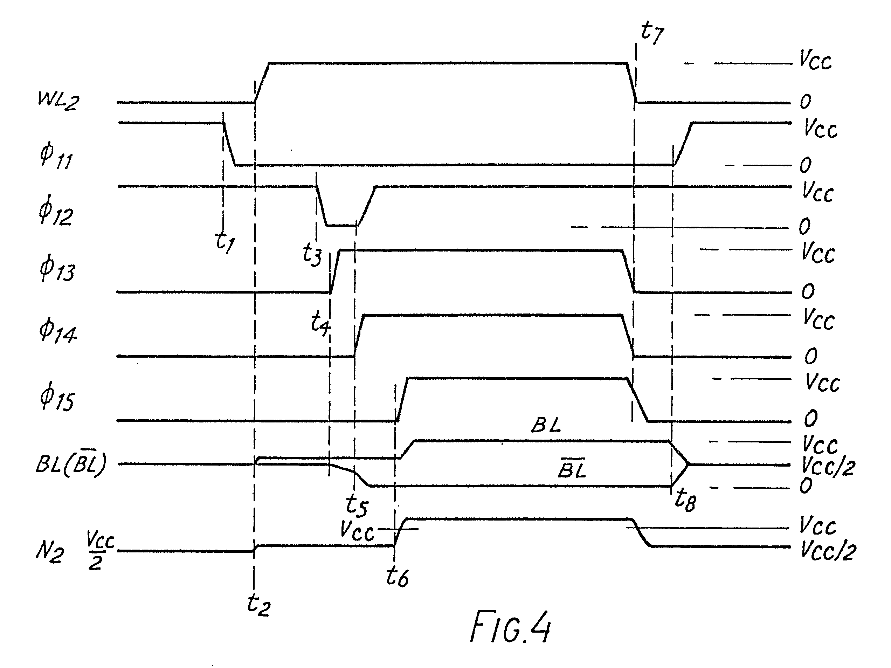

The operation of the circuit of Fig. 3 is described with reference to Fig. 4.

Prior to a time point $t_1$, a clock signal ${}^\emptyset 11$ is at a high level so as to keep potentials of the bit lines BL and $\overline{BL}$ at the same 1/2 Vcc level. Also, the nodes Na and Nb are set at the 1/2 Vcc through the transistors $Q_{25}$ and $Q_{26}$. At a time point $t_1$, the signal ${}^\emptyset 11$ changes from a high level to a low level to terminate a reset operation.

Then, at a time point $t_2$, the word line $WL_2$ is selected. In this case, it is assumed that the memory cell $MC_2$ addressed stores a "1" level, and therefore the bit line BL is raised slightly in potential while the potential of the bit line $\overline{BL}$ remains at 1/2 Vcc. The potentials of the bit lines BL and $\overline{BL}$ are applied to the first circuit nodes N3, N3' and transmitted to the nodes Nb and Na via the transistors $Q_{26}$ and $Q_{25}$, respectively. Then, a clock signal $\phi$12 changes from a high to a low level at a time point $t_3$ to render the transistors $Q_{25}$ and $Q_{26}$ non-conducting. Thus, the nodes Na and Nb are isolated from the nodes N3 and N3' and the bit lines $\overline{BL}$ and BL, respectively. Under this condition, a clock signal $\phi$13 changes from a low level to a high level at a time point $t_4$ to render the transistor $Q_{21}$ conducting. Thus, the sense amplifier commences amplification of the signal difference between the nodes Na and Nb. Then, at a time point $t_5$, the signal $\phi$12 returns to a high level so that the bit lines BL and $\overline{BL}$ and the nodes N3 and N3' are electrically connected to the nodes Nb and Na. Simultaneously, a clock signal $\phi$14 becomes active to render the transistor $Q_{22}$ conductive. The transistor $Q_{22}$ has a larger current capability, i.e. conductance, than the transistor $Q_{21}$, and hence the transistors $Q_{22}$ and $Q_{21}$ discharge the charge at the bit line $\overline{BL}$ effectively and rapidly. Thus, the bit line $\overline{BL}$ is discharged to the ground potential. Therefore, the transistor $Q_5$ is rendered non-conductive while the transistor $Q_51$ remains conductive. Therefore, the potential at the node N2 is slightly higher than 1/2 Vcc while the potential at the node $N2^1$ is at ground potential. Under this condition, a control signal $\phi$15 is raised to the Vcc level at a time point $t_6$. Therefore, the potential at the node N2 is raised above the Vcc level through the capacitor $C_2$ so that the transistor $Q_6$ is rendered conducting in the non-saturated region. Thus, the Vcc level is applied to the bit line BL without level reduction. Further, since the transistor $Q_51$ is conducting, the potential at the node $N2^1$ is kept at the ground level irrespective of the change of the control signal $\phi$15. Thus, a pull-up operation is achieved with respect to the bit line BL. Then, at a time point $t_7$, the word line $WL_2$ and the signals $\phi$13, $\phi$14 and $\phi$15 return to a low level and a reset period is introduced. Also, the signal $\phi$11 returns to a high level to render the transistor $Q_{27}$ conducting. Accordingly, the "1" level of the bit line BL and the "0" level of the bit line $\overline{BL}$ are short-circuit and both of the bit lines and the nodes Na and Nb are automatically changed to the 1/2 Vcc level.

As described above, an active pull-up circuit according to the present invention can be fabricated by the reduced number of elements, i.e. two transistors and a capacitor and it promotes large integration structure. Furthermore, a pull-up circuit of the invention does not require any special clock signal which is raised above the power voltage Vcc. Accordingly, a circuit having simple circuit structure and operable with a small power consumption can be obtained.

**Claims**

1. An active pull-up circuit comprising a voltage terminal (Vcc), a first circuit node (N3, N3'), a first field effect transistor (Q6, Q6') of an enhancement type having a drain-source path coupled between said first circuit node (N3, N3') and said voltage terminal (Vcc), a second field effect transistor (Q5, Q5') of a depletion type having a drain-source path coupled between said first circuit node (N3, N3') and a gate of said first transistor (Q6, Q6'), a capacitor (C2, C2') having a first terminal coupled to the gate of said first transistor (Q6, Q6'), a first means for applying a control signal (ø15) to a second terminal of said capacitor (C2, C2'), a second means (Nb, Q26, Na, Q25) for operatively applying a first signal to said first circuit node (N3, N3'), a third means (Na, Nb) for operatively applying a second signal to a second circuit node connected to a gate of said second transistor (Q5, Q5'), each of said first and second signals having a first level which makes said second transistor (Q5, Q5') conductive prior to a first time point (t1), said first signal taking one of a second level, which is substantially the same as said first level and does not change the conductive state of said second transistor (Q5, Q5'), and a third level, after said first time point (t1), said second signal taking the other of said second level and said third level, which makes said second transistor (Q5,Q5') non-conductive, after said first time point (t1), whereby when said first signal is at the second level and said second signal is at said third level the second field effect transistor (Q5, Q5') is non-conductive, the application of said control signal (ø15) to the second terminal of said capacitor (C2, C2') then causing the first transistor (Q6, Q6') to conduct and causing the voltage at said voltage terminal (Vcc) to be applied to said first circuit node (N3, N3').

2. The active pull-up circuit according to claim 1, characterised in that said first means raises the potential at said second terminal to the potential at said voltage terminal (Vcc) after said first and second signals take one and the other of said second and third levels.

3. The active pull-up circuit according to claim 1, characterised in that said first circuit node (N3, N3') and said gate of said second transistor (Q5, Q5') are connected to a pair of bit lines (BL, $\overline{BL}$) in a memory.

## Revendications

1. Circuit actif de tirage vers le haut comprenant une borne de tension (Vcc), un premier noeud de circuit (N3, N3'), un premier transistor à effet de champ (Q6, Q6') du type à accumulation comportant un trajet drain-source monté entre ledit premier noeud de circuit (N3, N3') et ladite borne de tension (Vcc), un second transistor à effet de champ (Q5, Q5') du type à épuisement comportant un trajet drain-source monté entre ledit premier noeud de circuit (N3, N3') et une grille dudit premier transistor (Q6, Q6'), un condensateur (C2, C2') ayant une première borne accouplée à la grille dudit premier transistor (Q6, Q6'), un premier moyen pour appliquer un signal de commande (ø15) à une seconde borne dudit condensateur (C2, C2'), un second moyen (Nb, Q26, Na, Q25) pour appliquer fonctionnellement un premier signal audit premier noeud de circuit (N3, N3'), un troisième moyen (Na, Nb) pour appliquer fonctionnellement un second signal à un second noeud de circuit relié à une grille dudit second transistor (Q5, Q5'), chacun desdits premier et second signaux ayant un premier niveau qui rend conducteur ledit second transistor (Q5, Q5') avant un premier instant (t1) , ledit premier signal prenant l'un d'un second niveau, qui est sensiblement le même que ledit premier niveau et ne change pas l'état conducteur dudit second transistor (Q5, Q5'), et d'un troisième niveau, après ledit premier instant (t1), ledit second signal prenant l'autre dudit second niveau et dudit troisième niveau, qui rend non conducteur ledit second transistor (Q5, Q5'), après ledit premier instant (t1), d'où il résulte que lorsque ledit premier signal se trouve au second niveau et que ledit second signal se trouve audit troisième niveau, le second transistor à effet de champ (Q5, Q5') est non conducteur, l'application dudit signal de commande (ø15) à la seconde borne dudit condensateur (C2, C2') ayant alors pour effet que le premier transistor (Q6, Q6') devient conducteur et ayant pour effet que la tension à ladite borne de tension (Vcc) est appliquée audit premier noeud de circuit (N3, N3').

2. Circuit actif de tirage vers le haut selon la revendication 1, caractérisé en ce que ledit premier moyen élève le potentiel à ladite seconde borne pour le porter au potentiel à ladite borne de tension (Vcc) après que lesdits premier et second signaux prennent l'un et l'autre desdits second et troisième niveaux.

3. Circuit actif de tirage vers le haut selon la revendication 1, caractérisé en ce que ledit premier noeud de circuit (N3, N3') et ladite grille dudit second transistor (Q5, Q5') sont connectés à une paire de lignes de bits (BL, $\overline{BL}$ ) dans une mémoire.

## Patentansprüche

1. Aktive Erhöhungsschaltung mit einem Spannungsanschluß (Vcc), einem ersten Schaltungsknoten (N3,N3'), einem ersten Feldeffekttransistor (Q6,Q6') eines Anreicherungstyps mit einem Drain-Source-Weg, der zwischen den ersten Schaltungsknoten (N3,N3') und den Spannungsanschluß (Vcc) geschaltet ist, einem zweiten Feldeffekttransistor (Q5,Q5') eines Verarmungstyp, mit einem Drain-Source-Weg, der zwischen den ersten Schaltungsknoten (N3,N3') und ein Gate des ersten Transistors (Q6,Q6') geschaltet ist, einem Kondensator (C2,C2') mit einem ersten Anschluß, der an das Gate des ersten Transistors (Q6,Q6') angeschlossen ist, einer ersten Einrichtung zur Zuführung eines Steuersignals (ø 15) an einen zweiten Anschluß des Kondensators (C2,C2'), einer zweiten Einrichtung (Nb,Q26,Na,Q25) zum betriebsmäßigen Zuführen eines ersten Signals an den ersten Schaltungsknoten (N3,N3'), einer dritten Einrichtung (Na,Nb) zum betriebsmäßigen Zuführen eines zweiten Signals an einen zweiten Schaltungsknoten, der mit einem Gate des zweiten Transistors (Q5,Q5') verbunden ist, wobei jedes der ersten und zweiten Signale einen ersten Pegel aufweisen, der den zweiten Transistor (Q5,Q5') vor einem ersten Zeitpunkt (t1) leitend macht, das erste Signal einen zweiten Pegel annimmt, der im wesentlichen der gleiche wie der erste Pegel ist und den Leitungszustand des zweiten Transistors (Q5,Q5') nicht ändert, und einen dritten Pegel nach dem ersten Zeitpunkt (t1), wobei das zweite Signal den anderen des zweiten Pegels und des dritten Pegels annimmt, der den zweiten Transistor (Q5,Q5') nicht leitend macht nach dem ersten Zeitpunkt (t1), so daß wenn das erste Signal auf dem zweiten Pegel ist und das zweite Signal auf dem dritten Pegel ist der zweite Feldeffekttransistor (Q5,Q5') nicht leitend ist, die Zuführung des Steuersignals (ø15) an den zweiten Anschluß des Kondensators (C2,C2') dann den ersten Transistor (Q6,Q6') leitend werden läßt und bewirkt, daß die Spannung am Spannungsanschluß (Vcc) an den ersten Schaltungsknoten (N3,N3') zugeführt wird.

2. Aktive Erhöhungsschaltung nach Anspruch 1, dadurch **gekennzeichnet**, daß die erste Einrichtung das Potenzial am zweiten Anschluß auf das Potential am Spannungsanschluß (Vcc) erhöht, nachdem das erste Signal und das zweite Signal einen und den anderen des ersten und des zweiten Pegels annehmen.

3. Aktive Erhöhungsschaltung nach Anspruch 1, dadurch **gekennzeichnet,** daß der erste Schaltungsknoten (N3,N3') und das Gate des zweiten Transistors (Q5,Q5') mit einem Paar Bit-Leitungen (BL,BL) in einem Speicher verbunden sind.

FIG.1   PRIOR ART

EP 0 168 246 B1

FIG.2 PRIOR ART

FIG.3

EP 0 168 246 B1

FIG.4